# EUROPEAN PATENT APPLICATION

(11) **EP 2 797 102 A1**
(43) Date of publication of application: **29.10.2014**
(21) Application number: 14165944.1
(22) Date of filing: 25.04.2014
(51) Int. Cl.: H01J 37/32, H01R 39/64

(54) **Semiconductor device**

(30) Priority: 26.04.2013 KR 20130047017
(71) Applicant: Allied Techfinders Co., Ltd, Gyeonggi-Do (KR); Suh, Kee Won, Gyeonggi-Do (KR)
(72) Inventor: Suh, Kee Won, Gyeonggi-Do (KR)
(74) Representative: Betten & Resch

(57) **Abstract**

A semiconductor device is disclosed, the semiconductor device including first member an second the e first member relatively rotating to the second member; and a conductive liquid or a metal brush provided the first and second members, the first and second members are electrically connected by the conductive liquid or the metal brush.

## Description

This application claims the benefit of earlier filing date and right of priority to Korean Patent Application No.10-2013-0047017, filed on April 26, 2013, the contents of which is hereby incorporated by reference in their entirety.

### BACKGROUND OF THE INVENTION

### Field of the invention

The teachings in accordance with the exemplary embodiments of this present invention generally relate to semiconductor devices such as etching, ashing devices, PECVD (Plasma Enhanced Chemical Vapor Deposition) and HDP_CVD (High Density Plasma Chemical Vapor Deposition, PEALD) configured to use and process wafers and LCD glass substrates.

### Description of Related Art

Plasma sources for use in forming fine patterns on the surfaces of substrates have been developed into various shapes in view of the necessity of finely forming the line width of a circuit pattern in the field of semiconductors and in view of the necessity of increasing the size of a glass substrate in the field of LCDs made of glass substrates.

Typical examples of plasma sources for producing plasma in semiconductor manufacturing devices include a CCP (Capacitively Coupled Plasma) source having a parallel plate geometry and an ICP (Inductively Coupled Plasma) source using an antenna coil. The CCP source has been developed by Tokyo Electron Ltd., Japan and Lam Research Corp., U.S.A., and the ICP source has been developed by Applied Materials Technologies, Inc. and Lam Research Corp., U.S.A.

The ICP source using an antenna coil provides advantages in that it has an ability to generate plasma under a low pressure and enjoys an increased plasma generation density. However, the ICP source causes many problems to a substrate as a work piece due to the non-uniform generation of plasma inherently resulted from the structure of the antenna. In the field of LCDs that makes use of glass substrates, the ICP source poses a problem in that plasma cannot be uniformly generated as the size of a glass substrate increases. Nevertheless, although the ICP source using an antenna coil is gradually ruled out due to many problems to a substrate, the importance of ICP source has re-surfaced and the ICP source can serve as an excellent plasma source that can cope with the ultra-fineness of a circuit line width.

In the field of LCDs that makes use of glass substrates, the ICP source poses a problem in that plasma cannot be uniformly generated as the size of a glass substrate increases. Thus, AMT of US, TEL OF Japan, ADP Engineering and Jusung Engineering Co., Ltd. of Korea have developed deposition equipment or etching equipment using parallel plate type CCP mode.

Meantime, although the CCP source is advantageous in generating uniform plasma, an electromagnetic field has a direct influence on a substrate as a work piece. Therefore, the electromagnetic field is apt to adversely affect the formation of a fine pattern on the work piece. Furthermore, since the CCP source has plasma generation density smaller than that of the ICP source, the CCP source is disadvantageous in appropriately forming a pattern as a line width grows narrower. Moreover, as a high level of power is applied to the CCP source in case of glass substrate of large area (7^{th} generation, 8^{th} generation), severe damages may be caused to the work piece and the semiconductor manufacturing device, which leads to increased manufacturing costs and difficulties.

Although the Korea Patent Registration Publication No.: 0324792 discloses application of modulation of low frequency power relative to high frequency power, it fails to teach a measure to generate a uniform plasma with reliability.

### SUMMARY OF THE INVENTION

The present invention is to provide a slip ring and a rotational assembly configured to minimize an electric resistance and power loss by allowing a power to be transmitted through a surface contact when the power is transmitted to a plasma source for generation/ rotation of plasma.

The present invention is also to provide a chamber configured to obtain a high density and uniform plasma from a limited area on a work piece through a liner inserted into the chamber and formed with a permanent magnet.

In one general aspect of the present disclosure, there is provided a semiconductor device, characterized by:
a first member and a second member, the first member relatively rotating to the second member; and
a conductive liquid filled between the first and second members or a metal brush.

Preferably, but not necessarily, the first and second members may be electrically connected by the conductive liquid or the metal brush.

Preferably, but not necessarily, the semiconductor device may further comprise a bearing inserted between the first and second members, wherein the bearing may be filled in with the conductive liquid.

Preferably, but not necessarily, the metal brush may be mounted at the second member, and provided with a contact part configured to slide-contact the first member, and a pressure part configured to apply a pressure to the contact part to a direction facing the second member to allow the contact part to contact the second member.

In another general aspect of the present invention, there is provided a semiconductor device, characterized by:
a chamber accommodated with a substrate; and
a plasma source formed at one side of the chamber to excite a reaction gas of the substrate introduced into the chamber into a plasma state, wherein the first and second members are provided at the plasma source, and the plasma source includes a rotational antenna arranged with a plurality of coils, a rotator to which the rotational antenna is mounted, and a housing rotatably supporting the rotator.

In still another aspect of the present invention, there is provided a semiconductor device, characterized by:
a chamber accommodated with a substrate;
a plasma source formed at one side of the chamber to excite a reaction gas of the substrate introduced into the chamber into a plasma state, and
a liner mounted inside the chamber, wherein the plasma source includes a rotational antenna arranged with a plurality of coils connected to a high frequency power, the antenna coil rotating more than 360° to generate a uniform plasma, and the liner is provided with a permanent magnet.

In still further general aspect of the present invention, there is provided a semiconductor device, characterized by:
a chamber accommodated with a substrate; and
a plasma source formed at one side of the chamber to excite a reaction gas of the substrate introduced into the chamber into a plasma state, wherein the plasma source includes a rotational antenna arranged with a plurality of coils connected to a high frequency power, the antenna coil rotating more than 360° to generate a uniform plasma, a cover configured to tight-seal the chamber is provided between the chamber and the plasma source, and the cover is provided at an inner edge thereof with a strong magnetic substance.

### ADVANTANGEOUS EFFECTS

**The semiconductor device according to the present invention can advantageously improve the conventional antenna coil structure provided in an inductively coupled plasma source and designed to generate a voltage difference in a process chamber, thereby minimizing the loss of a capacitive coupling electromagnetic field which would happen due to a voltage drop. The semiconductor device according to the present invention can advantageously accomplish a uniform plasma density distribution by making an antenna coil rotatable** in **an effort to improve the non-uniformity in a plasma density distribution which would occur in the conventional fixed-type antenna coil.**

**As a result, the semiconductor device according to the present invention can maximize the** radio frequency power transfer efficiency **by minimizing a plasma generation space** in the conventional antenna coil. Furthermore, **the semiconductor device according to** the present invention can easily change or modify the geometric structure of an antenna coil even wi thin a limited space, which helps increasing a plasma density and making a plasma generation density uniform.

**Furthermore, the semiconductor device according to the present invention can provide a reliable power to the antenna coil by charging a conductive liquid to a surrounding of the antenna coil or to the bearing during rotation of the antenna coil or by providing a metal brush, whereby plasma can be reliably generated.**

**Still furthermore, the semiconductor device according to the present invention can increase density and uniformity of plasma by fixedly mounting a permanent magnet on a fixed liner mounted at a periphery of the chamber because the plasma is generated in a rotating state.**

### BRIEF DESCRIPTION OF THE DRAWINGS

FIG. 1 is a side sectional view illustrating a semiconductor device having a rotational antenna according to the present invention.
FIG. 2 is a perspective view illustrating a rotational antenna according to an exemplary embodiment of the present invention.
FIG. 3 is a schematic diagram of the rotational antenna shown in FIG. 2.
FIG. 4 is a schematic diagram illustrating a rotational antenna according to another exemplary embodiment of the present invention.
FIG. 5 is a schematic diagram illustrating a rotational antenna according to a further exemplary embodiment of the present invention.
FIG. 6 is a partially enlarged sectional view illustrating a gas supply part of the semiconductor device shown in FIG. 1.
FIG. 7 is a plan view illustrating a gas supply plate according to the present invention.
FIG. 8 is a front view of the gas supply plate illustrated in FIG. 7.
FIG. 9 is a side sectional view illustrating another semiconductor device having a rotational antenna according to the present invention.
FIG. 10 is a cross-sectional view illustrating apart of another semiconductor device having a rotational antenna according to the present invention.
FIG. 11 is a cross-sectional view illustrating apart of still another semiconductor device having a rotational antenna according to the present invention.
FIG. 12 is a cross-sectional view illustrating another part of another semiconductor device having a rotational antenna according to the present invention.
FIG. 13 is a cross-sectional view illustrating another part of still another semiconductor device having a rotational antenna according to the present invent ion.
FIG. 14 is a schematic view illustrating a liner constituting a semiconductor device according to the present invention.
FIG. 15 is a schematic plan view illustrating a cover of a chamber according to the present invention.
FIG. 16 is a schematic cross-sectional view illustrating a cover of a chamber according to the present invention.

### DETAILED DESCRIPTION OF THE INVENTION

Hereinafter, exemplary embodiments of the present invention will be described in detail with reference to the accompanying drawings.

As used in the present invention, it is to be understood that the sizes and the shapes of the components shown in some of the drawings are illustrated in an exaggerated scale for the sake of clarity in explanation. In addition, the terms specifically defined herein in consideration of the construction and function of the present invention may have different meanings depending on an intent ion of a user or operator and the practice in the art. Therefore, the definition of the specific terms or words should be based on the contents across the specification.

The present invention is directed to a plasma source for a large-area work piece which can be used in processing a circular substrate. Furthermore, the present invention is also directed to a plasma source having enhanced adaptability for the size of the circular substrate and particularly suitable for use in a semiconductor manufacturing process in which a wafer is used as a work piece. Still furthermore, the present invention is directed to an ICP (Inductively Coupled Plasma) source for use in deposition devices (including PECVD, HDPCVD and PEALD devices), etching devices (including ashing devices) and the like, which are designed to process a substrate using plasma. The inductively coupled plasma is capable of independently generating plasma.

In addition, the plasma source according to the present invention is not bound by the area of a work piece to thereby improve adaptability, such that the present plasma source can be suitablyused in processing a glass substrate for an LCD or a CNT (Carbon NanoTube). The radio frequency power supplied from a high frequency power source (a radio frequency power source) to a single electrode through an impedance matcher is connected to at least two parallel antenna coils. The antenna coils are rotated at a speed of several rpm to several hundred rpm to generate plasma.

The present invention provides an ICP source that allows a user to increase a length of the antenna coils or to easily change a geometric shape of the antenna coils in conformity with the size of a substrate as a work piece, where the ICP source is positioned above a deposition device or an etching device.

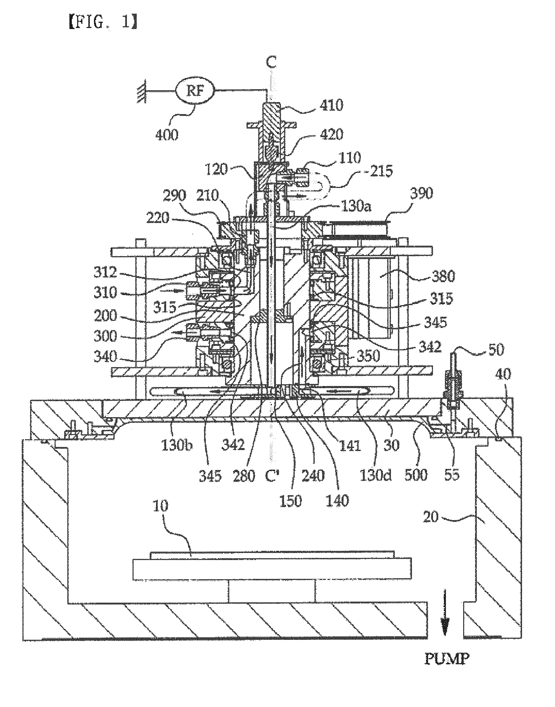

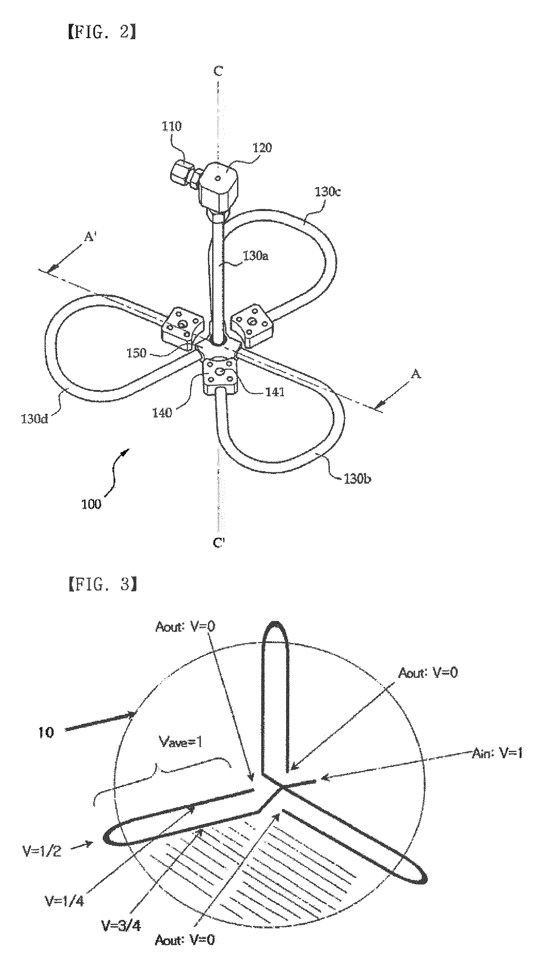

FIG. 1 is a side sectional view illustrating a semiconductor device having a rotational antenna according to the present invention, and FIG. 2 is a perspective view showing a rotational antenna according to an exemplary embodiment of the present invention. Structures and functions of a rotational antenna and a semiconductor device having the rotational antenna according to the present embodiment will be described in detail with reference to FIGS. 1 and 2.

An upper part of a chamber 20 is provided with a rotational antenna 100 serving as a plasma source, a rotator 200 to which the rotational antenna 100 is mounted, and a housing 300 for rotatably supporting the rotator 200. A lower part of the chamber 20 is connected to a pump to allow vacuum to be introduced into the chamber 20. An 0-ring 40 is placed on the upper part of the chamber 20 which in turn is covered and sealed by a cover 30. Preferably, the cover 30 is formed with a quartz glass plate. A substrate 10 and a gas supply plate 500 configured to uniformly supply a reaction gas are located inside the chamber 20. A reaction gas is excited in a plasma state by way of the plasma source arranged above the chamber 20.

As an alternative exemplary embodiment not illustrated in the drawings, it would be conceivable that the rotational antenna and the rotator are arranged within the chamber. In this case, the housing positioned outside the chamber and the rotator positioned inside the chamber need to be sealed off from each other so that the internal space of the chamber can be maintained under a vacuum condition. This is because the housing provided with a coolant supply part and a coolant discharge part is desirably arranged outside the chamber,

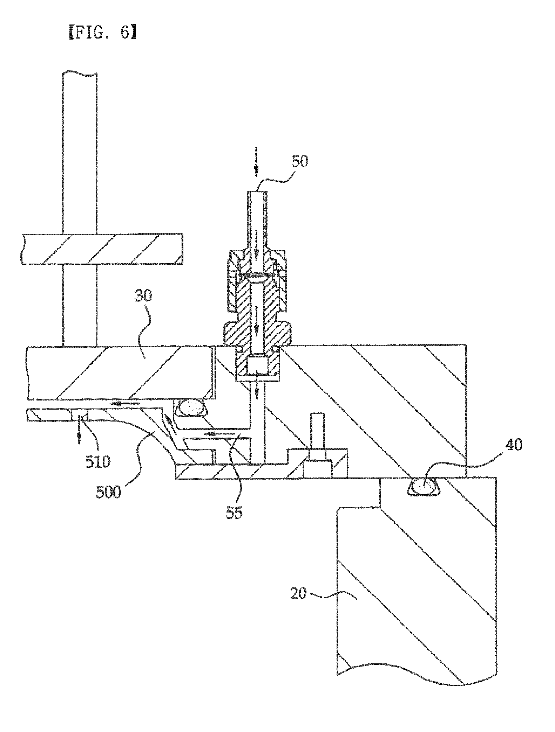

As will be further described later with reference to FIGS. 6, 7 and 8, a reaction gas such as an argon (Ar) gas suitable for activating plasma is evenly introduced into the chamber 20 from the outside of the plasma source via a gas inlet 50, a gas channel 55 and the gas supply plate 500.

High frequency power is supplied from a high frequency power source 400 to the rotational antenna 100 through a high frequency power connection part 410 having, e.g., an impedance matcher, and then a slip ring 420. The electromagnetic field induced in the rotational antenna 100 passes through the cover 30 made of quartz glass plate and is excited in the chamber 20 to generate plasma. The substrate 10 placed on a substrate support is processed by the plasma. At this time, radio frequency power of several hundred KHz to several hundred MHz can be employed.

As apparent in the above description, the most significant difference between the conventional inductively coupled plasma source and the present inductively coupled plasma source lies in that the rotational antenna 100 is provided in the present invention. The characteristic of the present invention lies in rotating a coil, whose characteristic is to uniformly generate plasma in a circumferential direction and cannot be real ized by the convent ional induct ively coupled plasma source formed with a fixed antenna coil. The rotational antenna 100 is mounted on the rotator 200 with an insulation member 280 interposed therebetween and is rotated together with the rotator 200. The rotator 200 assembled to the rotational antenna 100 is rotatably fitted into the housing 300. Bearings 350 are interposed between the rotational contact surfaces of the housing 300 and the rotator 200. A motor 380 is attached to the housing 300. The motor 380 and the rotator 200 are operatively connected to each other by means of belt pulleys 290 and 390. Upon rotation of the motor 380, a rotational force or torque is applied to the rotator 200 and the rotational antenna 100. Since the high frequency power connection part 410 needs to be rotated together, the slip ring 420 is used to transmit the radio frequency power.

The antenna according to an exemplary embodiment of the present invent ion is composed of a center coil 130a which defines a rotation center and three branch coils 130b, 130c and 130d which are connected in parallel to the center coil 130a. The branch coils 130b, 130c and 130d have a partially-opened curved shape such as a U-like shape or a C-like shape so that the proximal ends thereof connected to the center coil 130a and the distal ends thereof with grounding parts 140 can be arranged substantially at the same axial position. A connector 150 is used for assembling the branch coils 130b, 130c and 130d and the center coil 130a together.

A power input part 120, which is connected to the high frequency power source 400 through the slip ring 420, is provided at the distal end of the center coil 130a. The distal ends of the branch coils 130b, 130c and 130d having the grounding parts 140 come into contact with the rotator 200 to be grounded.

The coolant, which is supplied through a coolant supply part 310 of the housing 300, is introduced into a coolant channel 220 via a groove 312 defined between the rotational contact surfaces of the housing 300 and the rotator 200.

The coolant introduced into the coolant channel 220 reaches a coolant connection part 210. Since the rotator 200 is grounded and the high frequency power from the high frequency power source 400 is applied to the center coil 130a, the coolant connection part 210 and the coolant inlet 110 of the center coil 130a are connected to each other by an insulation hose 215 for the purpose of insulation.

In order to make it sure that the coolant can flow through the coils and the high frequency power from the high frequency power source 400 can be transmitted through the coils, the coils preferably include conductor pipes. While the coolant may not flow through the coils, use of the coolant is desirable to prevent heat loss which would otherwise occur when the radio frequency power is applied to the coils. The coolant, which enters the coolant inlet 110, flows via the center coil 130a to the respective branch coils 130b, 130c and 130d connected in parallel to the center coil 130a, and is then discharged through the coolant outlets 141 formed in the grounding parts 140.

In view of the fact that the grounding parts 140 are brought into contact with and rotate together with the rotator 200, the coolant outlets 141 of the grounding parts 140 are connected to a coolant channel 240 which is formed in the rotator 200. Thus, the coolant discharged through the branch coils 130b, 130c and 130d are introduced into the coolant channel 240 through the coolant outlets 141 and is allowed to flow toward the coolant discharge part 340 via a groove 342 which is sealed by a seal 345. The grooves 312 and 342 are defined in the housing 300 to extend in the circumferential direction. The grooves 312 and 342 are respectively sealed by seals 315 and 345 which are structured not to hinder rotation of the rotator 200 relative to the housing 300. The supply and discharge paths of the coolant are indicated by arrows in FIG. 1.

FIG. 3 is a schematic diagram of the rotational antenna shown FIG. 2.

Referring to FIGS. 2 and 3, another characteristic of the rotational antenna 100 according to the present invention resides in that the power input part 120 and the grounding parts 140 are arranged substantially coaxially. When viewed from an imaginary line C-C in FIG. 2, which is an axis of the rotational antenna 100, the voltage of the center coil 130a is, for example, V, and the voltage of the grounding parts 140 positioned near the imaginary line C-C is 0. Furthermore, in each branch coil 130b, 130c and 130d, an average voltage, which corresponds to the sum of the voltages applied to the two portions of each coil at any position along a radial direction, is constant as V. The term "radial direction" used herein means a direction which is extending away from a starting point about which the antenna 100 makes rotation and is perpendicular to the center coil 130a. For example, the radial direction in FIG. 2 indicates a direction that extends from the center coil 130a toward the reference characters A and A'. Therefore, in the present invention, the difference in voltages applied to the coils can be minimized because the power input part 120 is arranged coaxially with respect to the center coil 130a and the grounding parts 140 are located at positions adjacent to the center coil 130a,

Referring to FIG. 3, in the three branch coils which are flexed into a U-like shape and have the proximal ends and the distal ends adjacent to one another, a voltage drop occurs if a radio frequency input voltage of 1 is applied to the point A.sub.in where the branch coils are connected to the center coil. Therefore, voltages V at the points Aout as grounding points become 0. Also, in each branch coil, each of which is composed of two strands, if the voltage applied to one strand thereof is 1/4, the voltage applied to the other is 3/4. The sum of the voltages applied to the two strands of each branch coil becomes 1. Moreover, since the voltages applied to the two strands are 1/2 in the outermost radial point of each branch coil, the average voltage becomes 1.

From the standpoint of the substrate 10 as a work piece placed below the coils, there is provided an effect that the average voltage Vave=1 is uniformly applied by the branch coils 130b, 130c and 130d to the substrate 10 along the radial direction. This helps minimize the voltage difference would occur in the conventional antenna structure. This is because the branch coils 130b, 130c and 130d have a U-like or C-like shape such that the power input part 120 and the grounding parts 140 can be arranged substantially coaxially.

In the conventional fixed-type antenna coil, empty hatched spaces (as in FIG. 3) exist between coils. Therefore, the plasma density is non-uniformly distributed in these spaces when high frequency power is applied. In contrast, since the coil assembly is rotated to offset the empty spaces in the present invention, voltage differences resulting from the presence of the empty spaces (see FIG. 3) between the branch coils 130b, 130c and 130d can be cancelled with one another.

Hence, in the inductively coupled plasma source according to the present invention wherein the branch coils 130b, 130c and 130d have the U-like or C-like shape such that the power input part 120 and the grounding parts 140 can be arranged substantially coaxially, uniform plasma distribution can be obtained in both the radial direction and the circumferential direction, whose characteristic cannot be realized by the conventional inductively coupled plasma source.

The uniform plasma distribution helps reduce the volume of the chamber 20. Even when the size of the substrate 10 is enlarged, the uniform plasma distribution can be attained only by increasing the length of the U-like or C-like coils. Therefore, the present invention can be easily adapted for the next-generation wafers having a diameter of 300 mm, 450 mm or over.

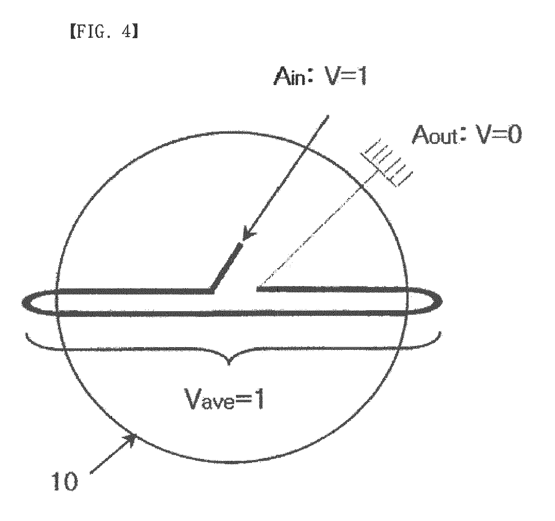

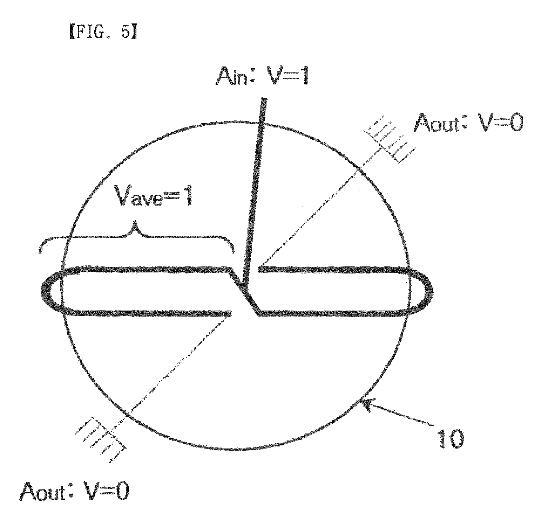

FIG. 4 is a schematic diagram illustrating a rotational antenna according another exemplary embodiment of the present invention, and FIG. 5 is a schematic diagram illustrating a rotational antenna according to a further exemplary embodiment of the present invention. FIG. 4 represents a case in which one branch coil is used, but FIG. 5 represents a case in which two branch coils are connected in parallel. When one branch coil is used, it is not necessary to distinguish serial connection from parallel connection.

When a radio frequency input voltage of 1 is applied during rotation of the antenna to the point Ain where the branch coil (s) is connected to the center coil, a voltage drop occurs and the voltage (s) V at the point (s) Aout as a grounding point (s) becomes 0. From the standpoint of the substrate 10 as a work piece placed below the coil (s), there is provided an effect that the average voltage Vave=1 is uniformly applied by the branch coil (s) to the substrate 10 along a radial direction. This helps minimize the voltage difference (s) generated in the structure of the rotational antenna.

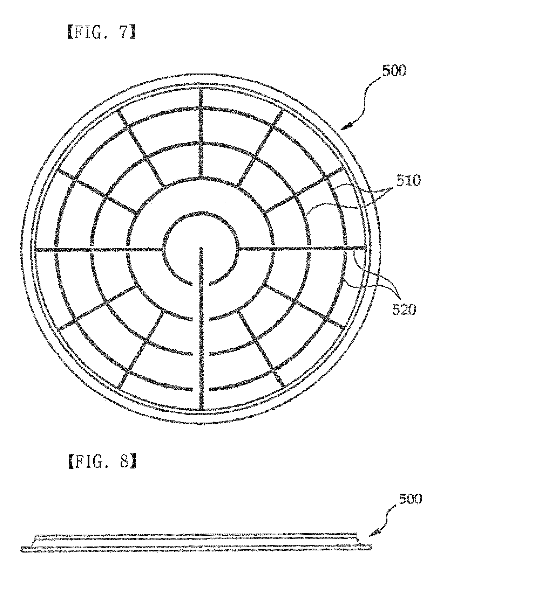

FIG. 6 is a partially enlarged sectional view illustrating a gas supply part of the semi-conductor device shown in FIG. 1, FIG. 7 is a plan view illustrating a gas supply plate 500 according to the present invention and FIG. 8 is a front view of the gas supply part illustrated in FIG. 7. The gas supply plate 500 of the semiconductor device according to the present invent ion will be described in detail with reference to FIGS. 6 through 8.

First, referring to FIG. 6, the reaction gas introduced through the gas inlet 50 defined in the wall of the chamber 20 is supplied into the chamber 20 via the gas channel 55, gas grooves 520 and gas holes 510 which are defined in the gas supply plate 500.

Next, referring to FIGS. 7 and 8, the reaction gas evenly dispersed through the gas grooves 520 defined in the circumferential direction and in the radial direction of the gas supply plate 500 is injected into the chamber 20 through the gas holes 510. In the gas grooves 520 and the gas holes 510 finely defined in the gas supply plate 500, the gas pressure is partially high. Therefore, no plasma is generated therein by the electromagnetic field induced by the radio frequency power. Accordingly, plasma is generated only within the chamber 20 and undesired generation of plasma in the gas supply passages is suppressed.

Meantime, in order for the antenna 100 thus described to normal ly operate, a reliable power should be supplied. The power supply to the antenna 100 may be applied between the slip ring 420 and the power grounding parts 140. One of the power supply lines must be electrically connected to the slip ring 420 and the other one must be connected to the power grounding parts 140. However, due to allowance of the slip ring 420, the slip ring 420 may not be temporarily and electrically connected to the power supply line during rotation of the antenna 100. Likewise, the power grounding parts 140 may be in the same condit ion of not being temporarily connected. The power grounding parts 140 are electrically connected to the rotator 200, bearing 350 and the housing 300, and the bearing 350 may not be electrically connected to the rotator 200 or to the housing 300 due to allowance of the bearing during rotat ion of the rotator 200 that rotates with the antenna 100.

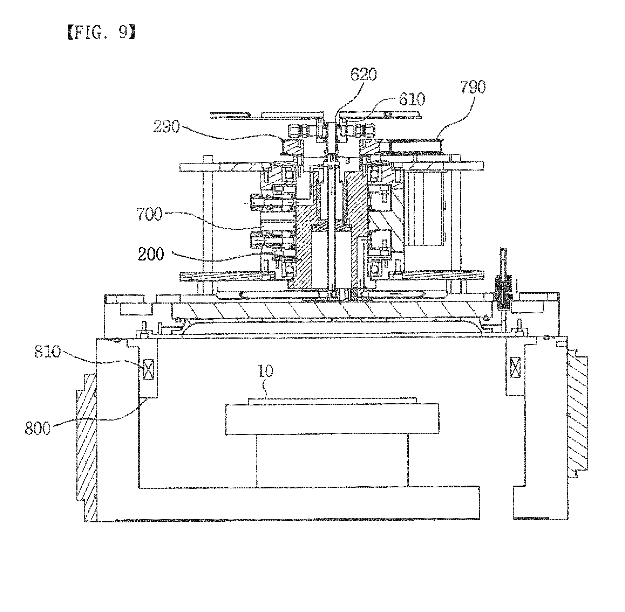

FIG. 9 is a side sectional view illustrating another semiconductor device having a rotational antenna according to the present invention.

The semiconductor device illustrated in FIG. 9 may include a first member and a second member, the first member relatively rotating to the second member, and a conductive liquid 690. 790 filled between the first and second members.

The first and second members are members that need to be electrically connected, and for example, the first member may be a slip ring 620 or a rotator 200, and the second member may be a high frequency power connector 610 or a housing 700.

The motor 380 and the rotator 200 provided at the housing 700 side are connected via belt pulleys 290, 790, and the rotator 200 and the rotating antenna 100 receive the rotation power in response to rotation of the motor 380. The first and second members may not be electrically connected due to manufacturing allowance and assembly allowance of the first and second members during relative rotation. Conduct ive liquids 690, 790 may be used to rel iably prevent the disconnect ion between the first and second members.

The conductive liquids 690, 790, which are fluidic materials capable of flowing electricity, may be filled between the first and second members. The conductive liquids 690, 790 may be liquid metals such as mercury and the like. From the mechanical viewpoint, the first and second members may maintain an electrically connected state by the conductive liquids 690, 790 even if the first and second members are electrically separated.

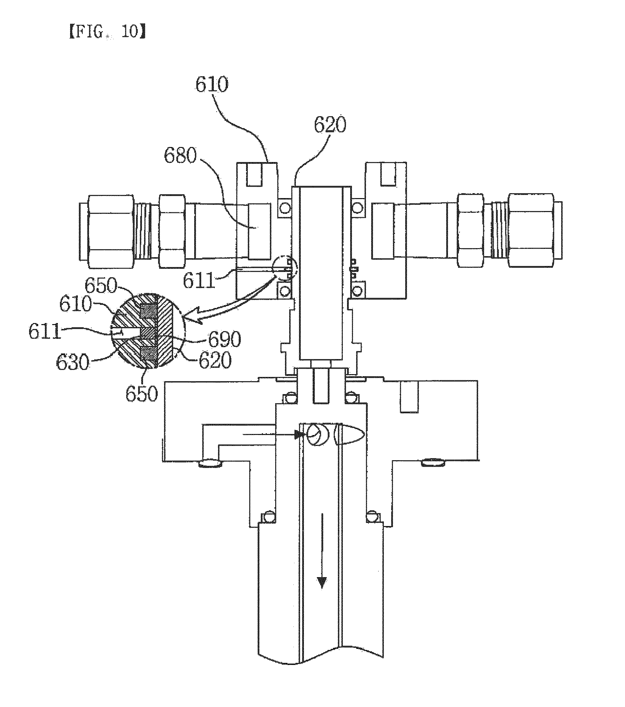

FIG. 10 is a cross-sectional view illustrating a part of another semiconductor device having a rotational antenna according to the present invention. FIG. 10 may be a view enlarging a part of the slip ring 620 of FIG. 9. A slip ring 620 and a high frequency power connector 610 are respectively disclosed in FIG. 10 as a first member and a second member. The high frequency power connector 610 as the second member may maintain a fixed state relative to the slip ring 610, and may be connected by one of the power supply lines.

The high frequency power connector 610 may be formed with a hollow hole accommodated by the slip ring 610 that rotates along with the antenna. As a result, the slip ring 620 may be accommodated into the high frequency power connector 610 which is the second member. Furthermore, in order to ensure the rotation of the slip ring 620, a bearing may be interposed between the hollow hole and the slip ring 620.

Although FIG. 10 shows that the hollow hole of the high frequency power connector 610 and slip ring 620 are almost contacted, the hollow hole of the high frequency power connector 610 and the slip ring 620 may be substantially distanced from each other for relative rotation. Thus, the electrical connection between the high frequency power connector 610 and slip ring 620 depends on a bearing provided therebetween.

The bearing may specifically include an inner race contact ing the slip ring, an outer ring contacting the high frequency power connector 610 and balls between the inner race and the outer ring. Thus, the inner race, balls and the outer ring that constitute the bearing must maintain an electrically connected state to allow the high frequency power connector 610 and the slip ring 620 to be electrically connected. That is, the balls must simultaneously contact the inner race and the outer ring. However, the balls may not be brought into contact with the inner race or the outer ring due to allowance of the bearings and/or shock generated by rotation of the slip ring 620, which means that the electrical connection between the high frequency power connector 610 and the slip ring 620 is disconnected.

According to the present invention, the conductive liquid 690 may be filled between the outer ring of the slip ring 620 which is a first member and an inner surface of the high frequency power connector 610 which is a second member, whereby the electrical connection between the high frequency power connector 610 and the slip ring 620 may be reliably maintained regardless of bearing state.

There may be various methods for filling the conductive liquids 690, 790 between the first and second members. For example, the conductive liquids 690, 790 may be filled between the first and second members through through holes 611, 710 formed at the second member. To be more specific, an inner surface of the second member may be provided with through holes 611, 710 that are connected to an external surface of the second member. The conductive liquids 690, 790 may be filled between the first and second members through the through holes 611, 710. First closures 630, 730 configured to close the through holes 611, 710 may be provided to prevent the conductive liquids 690, 790 filled between the first and second members from being discharged through the through holes 611, 710.

The first closures 630, 730 may include packing configured to close the through holes 611, 710 after the conductive liquids 690,710 are filled through the through holes 611, 710. The first closures 630, 730 may be arranged near to an entrance of the through holes 611, 710 at an inner surface of the second member.

Meantime, there is a need to prevent conductive liquids 690,790 filled between the first and second members from being discharged to other elements forming the semiconductor device or to the outside. To this end, second closures 650, 750 may be provided. The second closures 650, 750 may be mounted at an inner surface of the second member in a closed loop shape including the through holes 611, 710 thereinside. The second closures 650, 750 may be so-called an 0-ring. The conductive liquids 690, 790 introduced between the first and second members through the through holes 611, 710 may spread along an external surface of the first member or an inner surface of the second member. A spread scope of the conductive liquids 690, 790 may be limited by the second closures 650, 750 to a closed loop area formed by the second closures 650, 750.

The manufacturing cost may be reduced as an amount of conductive liquids 690,790 filled between the first and second members can be restricted by the second closures 650, 750. Furthermore, the first and second members may not be formed due to the structure of sealing by the conductive liquids 690,790 according to the second closures 650, 750.

The bearing may be also filled with conductive liquids. The conductive liquids filled in the bearing must have conductivity and must not hinder the function of bearing and must be robust to heat generated from the bearing. For example, the conductive liquids filled in the bearing may be conductive heat-resistant grease. The conductive liquids filled in the bearing may be filled between an inner race and an outer race of the bearing. At this time, the bearing may be provided with a sealing part configured to prevent the conductive liquids from leaking.

Meantime, the high frequency power connector 610 may be heated by the high frequency power applied thereto. When a temperature rises, a resistant value of the high frequency power connector 610 may increase to create a safety accident, such that there is a need of reducing the temperature of the high frequency power connector 610. To this end, the high frequency power connector 610 may be provided with a water jacket 680 in which coolant is circulated. The water jacket 680 may be connected by an inlet pipe for inputting coolant and an outlet pipe for outputting coolant heated in the course of cooling the high frequency power connector 610.

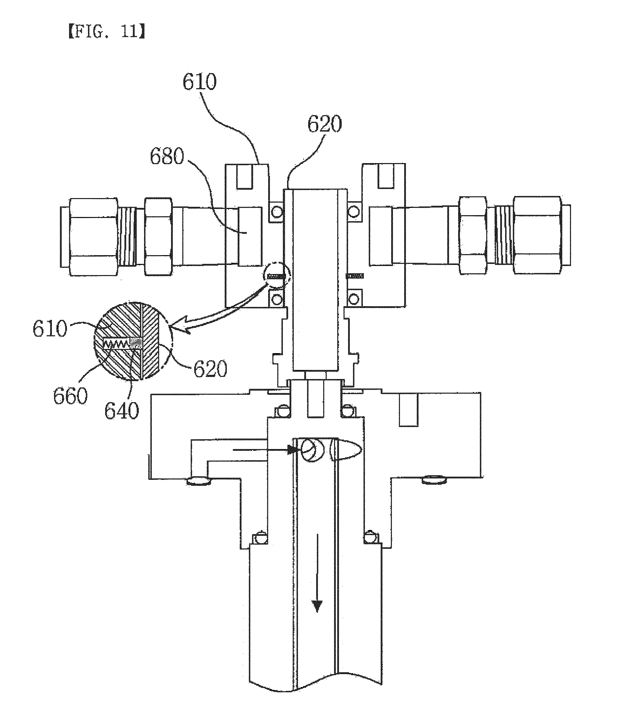

FIG. 11 is a cross-sectional view illustrating a part of still another semiconductor device having a rotational antenna according to the present invention.

As in FIG. 10, FIG.11 discloses a slip ring 620 as a first member and a high frequency power connector 610 as a second member, At this time, the first member may be the high frequency power connector 610, and the second member may be the slip ring 620. A metal brush instead of conductive liquids may be provided between the first and second members. The metal brush may be mounted at an inner wall surface of the high frequency power connector 610 to electrically connect the first and second members just like the conductive liquids. The relative rotation of the first and second members poses almost no problem of being restricted because the conductive liquids can minimize the frictional force. However, there is a need of periodically replacing the second closure 650 that is used to prevent the conductive liquid from being leaked.

The metal brush may be provided with a contact part 640 configured to slide-contact the first member and a pressure part 660 configured to apply a pressure to a direction facing the first member to allow the contact part 640 to contact the second member. The contact part 640 may be basically in a state of being electrically connected to the second member mounted with the metal brush. Thus, the first and second members may be electrically connected through the contact part 640, once the contact part 640 is brought into contact with the first member.

However, inasmuch as the first and second members are not in a fixedly connected state but in a rotating state, there is required a means configured to reliably slide-contact the contact part 640 to the first member, and the pressure part 660 may be used for this purpose. The pressure part 660 may include an elastic substance such as a spring configured to repulse the contact part 640 to a direction of the second member. According to the abovementioned metal brush, the relative rotational force of the first and second members may be partially offset by the slide-contact of the contact part 640 to the first member. However, as there is an advantage of being semi-permanently useable due to no need of requiring a closing means such as the second closure 650.

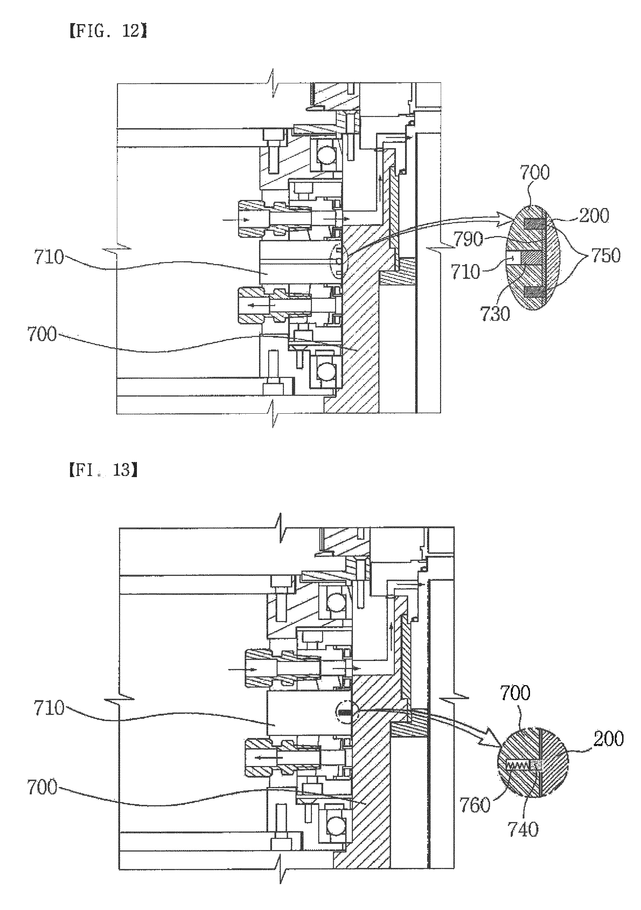

FIG. 12 is a cross-sectional view illustrating another part of another semiconductor device having a rotational antenna according to the present invention. FIG. 12 may be an enlarged view of the housing 700 of FIG. 9. FIG.12 discloses a rotator 200 as a first member and a housing 700 as a second member. The housing 700 of second member may maintain a fixed state relative to the rotator 200, and may be connected to another line of the power supply lines (ground terminal).

The housing 700 may be formed with a hollow hole accommodated by the rotator 200 that rotates along with the antenna. As a result, the rotator 200 which is the first member may be accommodated into the housing 200 which is the second member. Furthermore, a bearing may be interposed between the housing 700 and the rotator 200 in order to ensure rotation of the rotator 200. An electrical connection between the housing 700 and the rotator 200 depends on the bearing provided therebetween. In order to prevent the reliability of the electrical connection by the bearing, a conductive liquid 790 may be filled between an external surface of the rotator 200 which is the first member and an inner surface of the housing which is the second member, whereby the reliability of electrical connection between the rotator 200 and the housing 700 can be maintained regardless of bearing state. At this time, the housing 700 may be formed with a through hole 710 introduced by the conductive liquid 790 such as mercury as in the high frequency power connector 610, and may be also provided with a first closure 730 and a second closure 750.

Furthermore, the bearing arranged between the rotator 200 and the housing 700 may be also filled with conductive liquid such as conductive heat-resistant grease. The reliability of electrical connection between the first and second members can be realized by the conductive liquids 690, 790 filled between the first and second members, and the conductive liquid filled in the bearing.

FIG. 13 is a cross-sectional view illustrating another part of still another semiconductor device having a rotational antenna according to the present invention.

As in FIG. 12, FIG. 13 discloses a rotator 200 as a first member and a housing 700 as a second member. Of course, it should be apparent that the first member can be the housing 700, and the second member can be the rotator 200.

The housing 700 of second member may maintain a fixed state relative to the rotator 200, and may be connected to another line of the power supply lines (ground terminal). A contact part 740 and a pressure part 760 constituting a metal brush may be mounted at a groove formed at an inner wall surface of the housing 700 corresponding to the second member. The contact part 74d0 mounted at the housing 700 may slide-contact the rotator 200 by the pressure part 760. As a result, the housing 700 and the rotator 200 may be electrically connected via the contact part 740.

Now, back to FIG. 9, the semiconductor device according to the present invention may include a chamber 20 accommodated by a substrate, and a plasma source that excites a reaction gas of the substrate introduced into the chamber by being formed at one side of the chamber 20. The plasma source may include a slip ring 620 or a rotator 200 which is a first member, a high frequency power connector 610 or a housing 700 which is a second member.

In addition, the plasma source may also include a rotational antenna coaxially arranged with a plurality of coils connected in parallel to the frequency power. The rotational antenna may be assembled to the rotator 200 which is a first member. At this time, the housing 700 may rotatably support the rotator 200. According to the abovementioned plasma source, the antenna rotates to enable plasma to be evenly supplied into a reaction space inside the chamber 20. The plasma introduced into the chamber 20 strikes the substrate whereby the substrate can be cleaned, etched and deposited. This effect may be realized not only on the substrate but on the inner surface of the chamber 20.

In order to minimize the influence received on the inner wall surface of the chamber 20 by the plasma, a liner 800 may be mounted inside the chamber 20. The liner 800 may be mounted opposite to the inner wall surface of the chamber 20 and may be replaced by a new liner 800 when the liner 800 is damaged by the plasma. At this time, a permanent magnet 810 may be arranged at an outside of the liner 800 or the chamber 20 to prevent particles excited by the plasma from striking an inner wall of the liner 800 or the chamber 20.

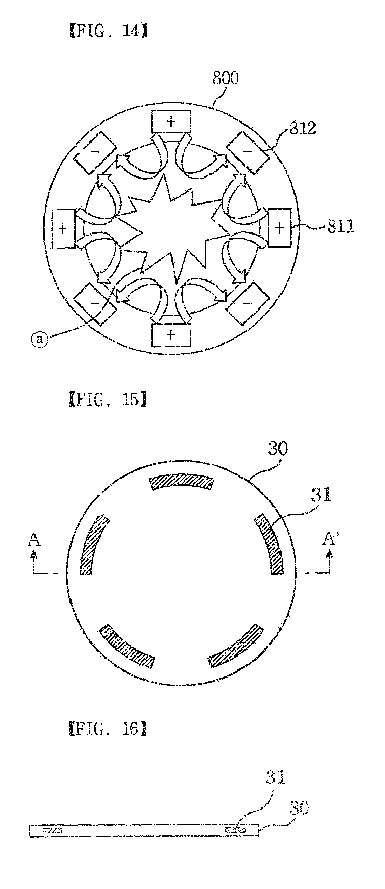

FIG. 14 is a schematic view illustrating a liner 800 constituting a semiconductor device according to the present invention. FIG. 14 illustrates a permanent magnet 810 arranged on the liner 800.

Referring to FIG. 14, a circular liner 800 is provided on a planar surface and a + electrode and a - electrode are magnetized on the liner 800 each at an equal angle.

As a result of the configuration thus described, magnetic force lines are generated as shown by arrows of FIG. 14, and plasma particles having polarity cannot approach the liner 800 or the chamber 20 by the magnetic force lines, and are in turn repulsed.

However, it can be noticed that the plasma particles generated from a center of the liner 800 on the planar surface can strike the liner 800 or the chamber 20 through a gap (a point to which an arrow enters or from which the arrow exits) of each magnetic force line when the plasma particles advance to radial directions. However, the semiconductor device according to the present invention, because of the rotational antenna, prevents the plasma particles from advancing to radial directions whereby the plasma particles advance to an inclined direction relative to the radial direction. Thus, the entry of plasma particles into the gap of the magnetic force lines can be fundamentally prevented. As a consequence, the plasma particles can be prevented from striking the inner wall surface of the liner 800 or the chamber 20 even if the magnetic polarity provided at an external surface of the liner 800 or the chamber 20 is not rotated and fixed.

In conclusion, the semiconductor device according to the present invention includes a chamber 20 mounted at one side with first and second members and accommodated by a substrate, and a liner 800 mounted at an inner surface of the chamber 20, where the liner 800 or the chamber 20 may be fixedly mounted at an external side thereof with a permanent magnet 810.

Meantime, the first and second members may include non-magnetic substance. When the first and second members include a magnetic substance, the plasma particles can advance toward the first member or the second member, whereby the first and second members may be damaged to deteriorate the processing reliability of the substrate. When the first and second members are formed with non-magnetic substance, this problem can be fundamentally prevented.

FIG. 15 is a schematic plan view illustrating a cover 30 of a chamber 20 according to the present invention, and FIG. 16 is a schematic cross-sectional view illustrating a cover 30 of a chamber 30 according to the present invention. FIG. 16 may illustrate a cross-section of the cover 30 of FIG. 15 along line A-A'.

The cover 30 of the chamber 30 may include a non-magnetic substance, an insulated material or the like. A distal end of the cover 30 may be mounted on the chamber 20 using an O-ring. At this time, the distal end of the cover 30 heat-exchanges with the O-ring or the chamber 20 to make a temperature of the distal end of the cover 30 lower than that of a center of the cover 30. When the temperature is lower than a predetermined value, the plasma inside the chamber 20 may be absorbed into the cover 30. In order to prevent this phenomenon, an inside of a margin of the cover 30 may be provided with a ferromagnetic substance 31 formed with a thin plate of iron contents. An eddy current may flow in the ferromagnetic substance 31 by the high frequency applied from the plasma source, and the ferromagnetic substance 31 is heated by the eddy current whereby the margin of the cover 30 may be heated even without a separate outside heat source. As a result, the margin of the cover 30 is heated by the ferromagnetic substance 31 to prevent the polymer inside the chamber 20 from being absorbed to the cover 30.

**While the present invention may have been disclosed with respect to several exemplary embodiments, such features or aspects may be variably modified by those skilled in the art, provided they come within the scope of the appended claims. The present invention may, however, be embodied in many different forms and should not be construed as limited to the embodiments set forth herein. Thus, it is intended that embodiments of the present invention may cover the modifications and variations of this invention provided they come within the metes and bounds of the appended claims and their equivalents.**

## Claims

1. A semiconductor device, **characterized by**:
a first member and a second member, the first member relatively rotating to the second member; and
a conductive liquid or a metal brush provided between the first and second members,
wherein the first and second members are electrically connected by the conductive liquid or the metal brush.

2. The semiconductor device of claim 1, **characterized in that** the first member is accommodated into the second member, the conductive liquid is filled between an outer surface of the first member and an inner surface of the second member, the inner surface of the second member is formed with a through hole connected to the outer surface of the second member, and wherein
the semiconductor device comprises: a first closure configured to close the through hole after the conductive liquid is filled in through the through hole; and
a second closure configured to be mounted at the inner surface of the second member in a closed loop shape including the through hole thereinside.

3. The semiconductor device of any of the preceding claims, further **characterized by** a bearing inserted between the first and second members, wherein the bearing is filled in with the conductive liquid.

4. The semiconductor device of any of the preceding claims, **characterized in that** the metal brush is mounted at the second member, and provided with a contact part configured to slide-contact the first member, and a pressure part configured to apply a pressure to the contact part to a direction facing the second member to allow the contact part to contact the second member.

5. The semiconductor device of any of the preceding claims, further **characterized by**:
a chamber mounted at one side with the first and second members for accommodating a substrate; and
a liner mounted inside the chamber, wherein
the liner or the chamber is fixedly mounted at an outside thereof with a permanent magnet.

6. The semiconductor device of any of the preceding claims, **characterized in that** the first and second members include a non-magnetic substance.

7. The semiconductor device of any of the preceding claims, further **characterized by**:
a chamber accommodated with a substrate; and
a plasma source formed at one side of the chamber to excite a reaction gas of the substrate introduced into the chamber into a plasma state, wherein the first and
second members are provided at the plasma source, and the plasma source includes a rotational antenna arranged with a plurality of coils, a rotator to which the rotational antenna is mounted, and a housing rotatably supporting the rotator.

8. A semiconductor device, **characterized by**:
a chamber accommodated with a substrate;
a plasma source formed at one side of the chamber to excite a reaction gas of the substrate introduced into the chamber into a plasma state, and
a liner mounted inside the chamber, wherein the plasma source includes a rotational antenna arranged with a plurality of coils connected to a high frequency power, the antenna coil rotating more than 360° to generate a uniform plasma, and the liner is provided with a permanent magnet.

9. A semiconductor device, **characterized by**:
a chamber accommodated with a substrate; and
a plasma source formed at one side of the chamber to excite a reaction gas of the substrate introduced into the chamber into a plasma state, wherein the plasma source includes a rotational antenna arranged with a plurality of coils connected to a high frequency power, the antenna coil rotating more than 360° to generate a uniform plasma, a cover configured to tightly-seal the chamber is provided between the chamber and the plasma source, and the cover is provided at an inner edge thereof with a strong magnetic substance.
